# EUROPEAN PATENT APPLICATION

(11) **EP 4 398 106 A1**
(43) Date of publication of application: **10.07.2024**
(21) Application number: 24150596.5
(22) Date of filing: 05.01.2024
(51) Int. Cl.: G06F 11/14

(54) **COMPUTER NETWORK SYSTEM RECOVERY BASED ON NON-LINEAR DATA RECOVERY MODELS**

(30) Priority: 05.01.2023 US 202363437209 P
(71) Applicant: The Bank of New York Mellon, New York, NY 10286 (US)
(72) Inventor: SCAGNELLI, Steven, New York, 10286 (US); DONG, Kelly, New York, 10286 (US); HUANG, Yu Xuan, New York, 10286 (US); JOHNSON, Daniel C., New York, 10286 (US); LIU, Yuwei, New York, 10286 (US)
(74) Representative: V.O.

(57) **Abstract**

The disclosure relates to systems and methods of modeling recovery of a Computer Network System (CNS) based on real-world recovery operations that are non-linear. The system may use a bin packing model that simulates recovery that eliminates idle times in linear estimates for data recovery. For example, the bin packing model may model recovery by actively simulating real-world conditions during recovery in a non-linear fashion. In particular, the bin packing model may fill the active bin with data objects that can be processed and the queue will include data objects waiting to be recovered. As a data object in the active bin is recovered, recovery of another data object may be made available. As such, the bin packing model may move a data object in the queue to the active bin as recovery progresses. Such progression is non-linear and modeled as such.

## Description

### BACKGROUND

Availability, or uptime, of computer network systems is becoming increasingly important as reliance on computer networks is ubiquitous. In the best case scenario, the unavailability, or downtime, of these systems may cause inconvenience to users and/or loss of revenue. In the worst case scenario, the downtime may cause the outage of mission critical services. Various events may cause downtime of computer network systems. Examples of such events may include device or service failure due to end of life, software or hardware bugs, malicious attacks, and improper maintenance, to name a few. Recovery is the process of restoring some or all functionality of computer network systems to a previous (operational) state after the occurrence of an event that causes a downtime. For example, recovery may include restoring an ecosystem from bare metal devices to an operational state.

Because of the critical nature of computer network systems, organizations may implement recovery plans to mitigate against downtimes. However, because of the complexity of modern computer network systems, determining when a system or service can be recovered presents various issues. For example, in some legacy systems, backup and restore mechanics operated in a linear fashion because older media, such as tape or mechanical hard drives, accepted data in-line. Because of this linear operation, data was deposited in the order it was read and therefore restored in sequence. Limiting factors for these legacy restoration systems were the speed at which the read mechanism could reach the beginning of backup data, and speed at which it could be written to restore the data. Thus, relatively simple recovery estimates based solely on the amount of data and number of devices to which the data was to be restored were sufficient to determine the time required to backup and restore data. However, modern computer network systems may use sophisticated memory having read and write operations that are non-linear and have complex relationships between system components. These and other factors may make generating recovery predictions difficult using linear techniques.

### SUMMARY

Various systems and methods may address the foregoing and other problems. For example, a system may model recovery of a Computer Network System (CNS) based on real-world recovery operations that are non-linear. The system may use a bin packing model that simulates recovery in a way that eliminates idle times that can make linear estimates inaccurate. For example, linear estimates may be based on an assumption that all recovery processes in a given concurrent recovery operation will complete at the same time. Thus, linear estimates may be based on the number of devices to be recovered and amount of data to be restored for such recovery on the assumption that data read/write operations occur linearly and sequentially. However, real-world recovery in a modern CNS may use storage such as sold-state drives (SSDs) that are not necessarily written or read sequentially. As such, read and write operations of a modern CNS may be non-linear. Thus, systems that use linear estimates for modern CNSs will assume there is idle time during recovery when in fact recovery may continue non-sequentially and without such idle delays, causing an over-estimate or other inaccuracies in the linear estimate.

The bin packing model may model recovery by actively simulating real-world conditions during recovery in a non-linear fashion. To do so, the bin packing model may use a recovery pattern, an active bin and a queue. The recovery pattern may include data that specifies a number of available streams for recovery and a recovery speed of each stream. The active bin may store data objects that are currently being recovered in a simulated recovery. The active bin may therefore be based on the recovery pattern. In other words, the number of data objects in the active bin may be based on the concurrent recovery limit. The queue may store data objects that are waiting to be recovered in the simulated recovery.

Upon instantiation, the active bin will be filled with the data objects that can be processed based on the recovery pattern and the queue will include the remaining data objects waiting to be recovered. As a data object in the active bin is recovered based on the recovery pattern, recovery of another data object may be made available. As such, the bin packing model may move a data object in the queue to the active bin as recovery progresses. Such progression is non-linear and modeled as such.

For example, the bin packing model may simulate recovery based on progression through a plurality of slices and estimate a slice recovery time for each slice. The bin packing model may generate an overall recovery time estimate for the recovery based on the slice recovery times. A slice is a representation of a period of time in which data objects in the active bin are being recovered concurrently based on the number of available streams specified in the recovery pattern. The first slice starts when the active bin is initially processed and ends when the first data object in the active bin has been recovered (this will be the smallest-sized data object in the active bin). Subsequent slices (other than a last slice) start when the queue is non-empty and the prior slice ends. The subsequent slices end when a data object in the active bin is recovered. The last slice starts when the queue is empty and the prior slice ends. The last slice ends when the largest data object remaining in the active bin is recovered. Progression through slices may proceed as follows.

The bin packing model may identify one or more data objects having the smallest size in the active bin that is being processed in a given (current) slice. More than one data object may have the smallest size in a given slice. The bin packing model may determine a slice recovery time, which is the amount of time to recover the smallest data object based on its size and the recovery speed. The bin packing model may subtract the size of the smallest data object from each size of the remaining data objects in the active bin for the current slice and remove all data objects in the active bin that have the smallest size. Doing so simulates recovering the removed data objects and ends a corresponding slice.

The bin packing model may determine whether more data objects are in the queue. If so, this means that the queue is not empty. Accordingly, the bin packing model may move a next data object in the queue to the active bin. It should be noted that more than one data object may be moved from the queue to the active bin at a given slice transition. Moving one or more data objects from the queue to the active bin starts the next slice. The bin packing model may repeat the slice transitions until the queue is empty.

When the queue is empty, this means that any remaining data objects in the active bin represents the last slice. The bin packing model may identify the data object having the largest size remaining in the active bin for the last slice. The bin packing model may determine a last slice recovery time for the last slice, which is the amount of time to recover the largest data object based on its size and the recovery speed. The bin packing model may sum the slice recovery times with the last slice recovery time to determine the recovery time estimate.

The system may use the recovery time estimate in various ways. For example, the system may, in response to a user request to simulate recovery of a portion or all of the CNS, generate a recovery prediction that includes the recovery time estimate, which may be used in computational loss preparedness and mitigation planning.

In some examples, the user may request various automated simulation scenarios for recovery decision support. For example, an automated simulation scenario may include an simulation of how changes in a Line of Business (LOB) minimum needs and priority would impact the availability of the LOB. For example, to simulate this scenario, the priority information and identification of the portion of the CNS to be recovered may be configured accordingly. Different variants may be iterated to assess how different LOB minimum needs and priority impact recovery.

Another automated simulation scenario may include determining how long different partial recoveries of a CNS would take in comparison to a full recovery. To simulate this scenario, the identification of the portion (or all) of the CNS to be recovered may be configured accordingly.

Another automated simulation scenario may include determining various minimum viable recoveries (MVRs), including an amount of time for recovery to the minimum viable recovery (MVR) and the cost to achieve such MVR. An MVR may refer to the minimum computational ability of a CNS or portion thereof to provide a specified minimum level of a service provided by the CNS. To simulate this scenario, the identification of the portion of the CNS that constitutes a MVR be configured accordingly and a computation of the time for recovery and cost to achieve such recovery may be determined. The cost may include an analysis of the cost of recovery systems needed to achieve the MVR. In particular, by configuring one or more recovery patterns, the system may simulate different amounts of recovery resources (such as recovery devices and/or software in recovery systems) used for recovery to determine recovery times that those resources will achieve and the cost those recovery devices will require.

Another automated simulation scenario may include improving recovery times or other aspects of recovery systems by replacing, adding, and/or removing recovery resources to improve recovery times. To simulate this scenario, one or more recovery patterns may be iteratively modified to represent changes to recovery resources and simulating their effect on the recovery prediction.

Another automated simulation scenario may include testing the effects of reduced recovery capacity such as to simulate outages of recovery systems. To simulate this scenario, one or more recovery patterns may be modified to represent reduced number of available streams and/or recovery speed in the recovery patterns, and simulating their effect on the recovery prediction.

In some examples, the system may maintain a historical record of the recovery predictions to show changes over time based on data growth, application use, and/or other changes over time of the CNS. In this manner, data regarding historical and current performance may be compared.

### BRIEF DESCRIPTION OF THE DRAWINGS

Features of the present disclosure may be illustrated by way of example and not limited in the following figure(s), in which like numerals indicate like elements, in which:
FIG. 1 illustrates an example of a system for recovery modeling of a computer network system;
FIG. 2 illustrates an example of a data flow for recovery modeling of a computer network system;
FIG. 3 illustrates an example of a method used by a bin packing model for estimating recovery time;
FIG. 4 illustrates an example of queuing data objects to be recovered for estimating recovery time based on a bin packing model; and
FIG. 5 illustrates an example of a method for generating a recovery prediction based on recovery modeling of a computer network system.

### DETAILED DESCRIPTION

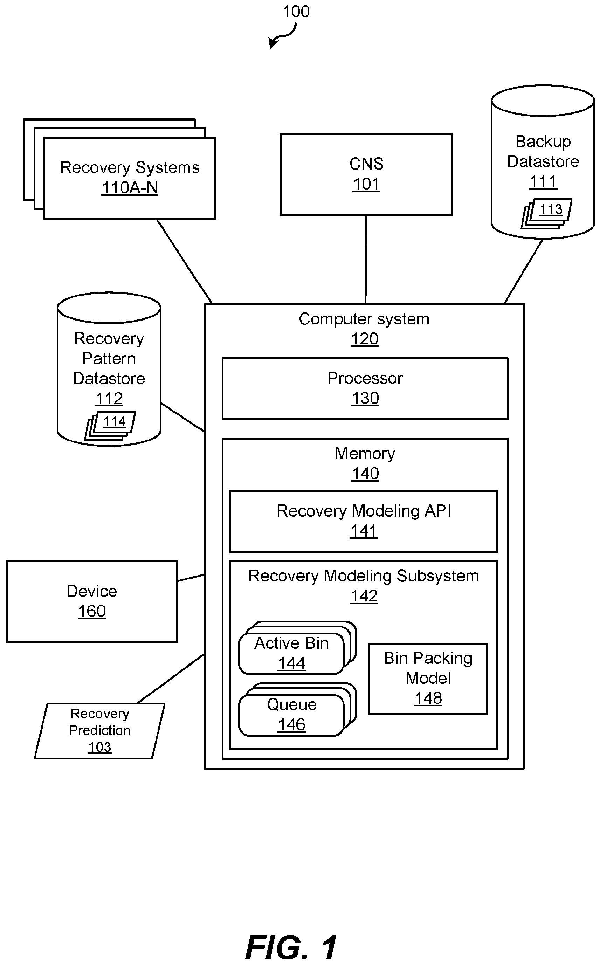

FIG. 1 illustrates an example of a system 100 for recovery modeling of a computer network system (CNS) 101. The system 100 may include one or more recovery systems 110 (illustrated as recovery systems 110A-N), a recovery pattern datastore 112, a computer system 120, a device 160, and/or other features. When available, to be in an operational state, the CNS 101 may use one or more data objects 113. An operational state refers to a state of a CNS during which the CNS may perform one or more operations. In an operational state, a CNS may be fully operational or partially operational. A data object 113 is data that the CNS 101 uses to be in an operational state. For example, a data object 113 may include system configuration data, installed software, system data, network configurations, and/or other data used by the CNS 101 to be operational. Some or all of the data objects 113 may be stored in backup copy in one or more backup datastores 111. When a portion or all of the CNS 101 experiences a downtime that requires recovery, some or all of the data objects 113 used by the CNS 101 may need to be recovered.

A recovery system 110 may recover a portion or all of the CNS 101. To perform recovery, the recovery system 110 may access one or more of the backup datastores 111 that stores the data objects 113 used by the CNS 101. During recovery, the recovery system 110 may read the data objects 113 from the backup datastore(s) 111 and write the data objects 113 into a recovered version of the CNS 101. Different organizations may use different types and/or configurations of recovery systems 110. Thus, not all recovery systems 110 will perform the same way as one another. The system may specifically model a given set of one or more recovery systems 110 that are implemented to recover a portion or all of a specific CNS 101.

The computer system 120 may simulate recovery of a portion or all of the CNS 101 to generate a recovery prediction 103. For example, the computer system 120 may simulate the read and/or write operations of the recovery system 110. The recovery prediction 103 may include a predicted complete recovery time, fractional (such as minimum needs) recovery time, first available recovery time, application standalone recovery time, total ecosystem recovery time, a monetary cost of the recovery, and/or other estimated values that may be required to recover a portion or all of the CNS 101. Complete recovery time means an amount of time required to restore full operations or service levels of all or portion of the CNS 101.

In some examples, the computer system 120 may generate the recovery prediction 103 based on one or more recovery patterns 114, which may be stored in the recovery pattern datastore 112. A recovery pattern 114 is data that indicates a capacity to recover data. For example, the recovery pattern 114 may include data that indicates a number of streams available to recover data, a recovery speed of each stream, and/or other data that indicates the capacity to recover data. A stream is a connection over which data may be transmitted for recovery from one device or storage to another device or storage. The recovery speed is an amount of data that may be recovered in a unit of time on a given stream. The recovery speed may depend on the read/write capabilities of a recovery system 110, a write capacity of a device or storage of the CNS 101 being recovered, a network capacity of a network that connects the recovery system 110 and the CNS 101, and/or other factors. Thus, one stream may have the same or different recovery speed from another stream. Furthermore, different recovery systems 110 may have different recovery capacities, whether because they have a different numbers of recovery devices and/or whether they use recovery devices having a different number of streams or recovery speed. Thus, a recovery pattern 114 may be specific to one or more recovery systems 110 that are used to recover the CNS 101. Different organizations may use different combinations of recovery systems 110. As such, a specific recovery system 110 and/or combination of different recovery systems 110 may be modeled by the computer system 120 using recovery patterns 114 that are specific to one or more recovery systems 110 that are to recover a portion or all of the CNS 101.

To facilitate recovery modeling, the computer system 120 may include a processor 130 and a memory 140. The processor 130 may include one or more of a digital processor, an analog processor, a digital circuit designed to process information, an analog circuit designed to process information, a state machine, and/or other mechanisms for electronically processing information. Although processor 130 is shown in FIG. 1 as a single entity, this is for illustrative purposes only. In some embodiments, processor 130 may comprise a plurality of processing units. These processing units may be physically located within the same device, or processor 130 may represent processing functionality of a plurality of devices operating in coordination.

The processor 130 is programmed to execute one or more computer program components. The computer program components may include software programs and/or algorithms coded and/or otherwise embedded in processor 130, for example. In some examples, as illustrated, the computer program components that program the processor 130 may be stored in the memory 140. The memory may include an electronic storage. The electronic storage may include non-transitory storage media that electronically stores information. The electronic storage media of the electronic storages may include one or both of (i) system storage that is provided integrally (e.g., substantially non-removable) with servers or client devices or (ii) removable storage that is removably connectable to the servers or client devices via, for example, a port (e.g., a USB port, a firewire port, etc.) or a drive (e.g., a disk drive, etc.). The electronic storages may include one or more of optically readable storage media (e.g., optical disks, etc.), magnetically readable storage media (e.g., magnetic tape, magnetic hard drive, floppy drive, etc.), electrical charge-based storage media (e.g., EEPROM, RAM, etc.), solid-state storage media (e.g., flash drive, etc.), and/or other electronically readable storage media. The electronic storages may include one or more virtual storage resources (e.g., cloud storage, a virtual private network, and/or other virtual storage resources). The electronic storage may store software algorithms, information determined by the processors, information obtained from servers, information obtained from client devices, or other information that enables the functionalities described herein.

The one or more computer program components or features stored by the memory 140 may include a recovery modeling Application Programming Interface ("API") 141, a recovery modeling subsystem 142, an active bin 144, a queue 146, a bin packing model 148, and/or other components or functionality. It should be noted that the processor 130 may be configured to execute or implement one or more of the components and/or features stored in the memory 140 by software; hardware; firmware; some combination of software, hardware, and/or firmware; and/or other mechanisms for configuring processing capabilities on processor 130.

The recovery modeling API 141 may provide one or more API calls that are used to interact with the recovery modeling subsystem 142, which models recovery of the CNS 101 to generate the recovery prediction 103. The recovery modeling API 141 may be implemented as a REpresentational State Transfer (REST) API, a Simple Object Access Protocol (SOAP) API, and/or other type of API or service. The recovery modeling subsystem 142 may execute the bin packing model 148 to generate a recovery time estimate, which may be included in the recovery prediction 103. The bin packing model 148 may simulate recovery of a portion or all of the CNS 101 in a non-linear fashion using time-based recovery slices using the active bin 144 and the queue 146.

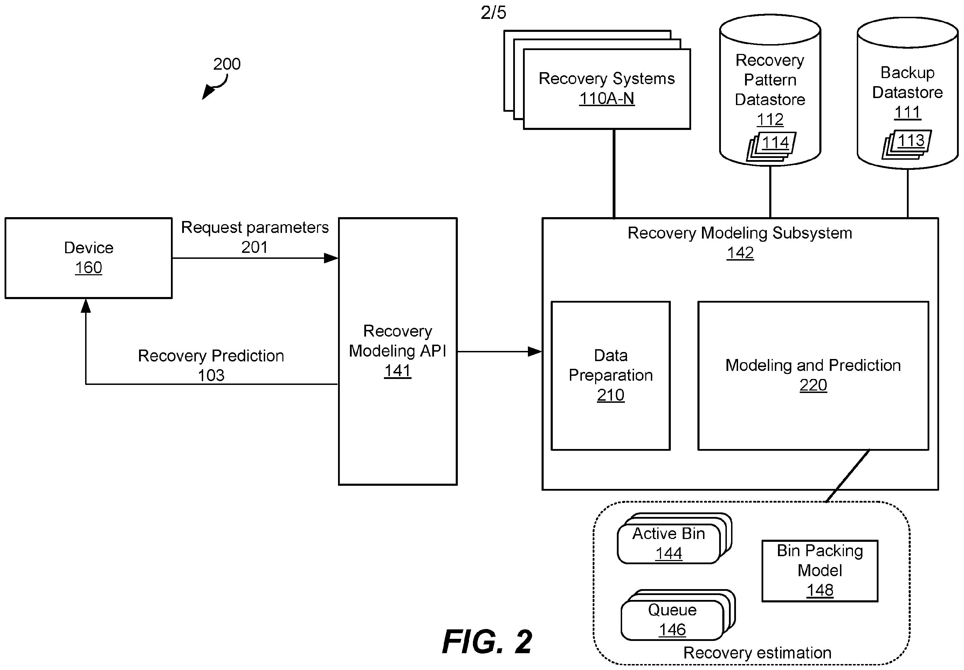

An example operation of the system 100 will be described with reference to FIG. 2, which illustrates an example of a data flow 200 for recovery modeling of the CNS 101. A user may use a device 160 to make one or more API calls to the recovery modeling API 141. For example, an API call may make a request to generate the recovery prediction 103. The request may be made in other ways other than an API call as well or instead. Furthermore, the request may be made via an automated process. Regardless of the manner in which the request is made, the request may include one or more request parameters 201 that define execution of recovery modeling to generate the recovery prediction 103. The request parameters 201 may include an identification of a portion or all of the CNS 101 for recovery modeling, priority information, one or more hypothetical recovery conditions that define one or more hypothetical scenarios, and/or other parameters.

The identification of the portion or all of the CNS 101 may include an identification of a specific application or set of applications for recovery, a specific line of business (LOB) or set of LOBs for recovery, a specific device or set of devices for recovery, all of the CNS 101 for recovery, and/or other portion of the CNS 101 for which recovery is to be modeled to generate the recovery prediction 103. An LOB as used herein refers to a set of products, software, or services provided by at least a portion of the CNS 101. To recover a specific LOB, a recovery system 110 may recover at least a portion of data used by the portion or all of the CNS 101 that is involved in providing the specific LOB.

The priority information may indicate an order of priority in which to recover portions of the CNS. For example, the priority information may include an LOB priority that prioritizes recovery of specified one or more LOBs, an application or set of applications priority, and/or other prioritization. In these examples, the devices that implement or otherwise provide the priority LOBs and/or applications will be recovered first before other devices. Other request parameters may include data that specifies a minimum needs per device per application and/or per LOB, deduplication of applications based on LOB membership, restore pattern per device per application, definitions of recovery patterns, specification of simultaneous restorations, data rates per restore, and/or other parameters.

The one or more hypothetical recovery conditions may include a simulated capacity or load of the one or more recovery systems 110 that are available to perform recovery operations. In these examples, the recovery prediction 103 may be made based on a hypothetical capacity or load impairment. For example, a user may obtain a recovery prediction 103 in a hypothetical scenario in which half (or other proportion) of the capacity or load of the one or more recovery systems 110 is available. In this manner, the system enables contingency planning to account for a hypothetical circumstance that a portion of recovery capabilities is lost or is otherwise unavailable.

The recovery modeling subsystem 142 may perform data preparation 210 and modeling and prediction 220. During data preparation 210, the recovery modeling subsystem 142 may identify, based on the request, the data objects 113 that are necessary for recovery (or simulated to be recovered by the recovery modeling subsystem 142 to generate the recovery prediction 103). A data object 113 may be necessary for recovery when the data object is directly or indirectly used by the application, set of applications, device, set of devices, LOB, set of LOBs, portion of CNS 101, or entire CNS 101 specified for recovery in the request. Each data object 113 may be a sizedefinable chunk of data such as a file or other discreet data. For example, the recovery modeling subsystem 142 may identify data objects 113 to be recovered from the backup datastore 111 so that recovery of such data objects 113 may be modeled to generate the recovery prediction 103. Thus, recovery modeling subsystem 142 may identify a plurality of data objects 113 and a size of each data object to be recovered.

During data preparation 210, the recovery modeling subsystem 142 may process any priority information to de-duplicate the data objects 113 and prioritize recovery of the data objects. The recovery modeling subsystem 142 may apply recovery patterns 114 based on application and device settings for the recovery systems 110 and/or other resources. The recovery modeling subsystem 142 may order devices of the CNS to recover based on the LOB, recovery pattern, applications, device sizes, and/or other factors.

During modeling and prediction 220, the recovery modeling subsystem 142 may simulate a recovery process by one or more recovery systems 110 to generate the recovery prediction 103. To do so, the recovery modeling subsystem 142 may use a bin packing model 148. The bin packing model 148 is a computational model for simulating recovery of the CNS 101 specified for recovery modeling. The bin packing model 148 may take into account idle times and/or availability of devices that are in the recovery system 110 to simulate recovery of the data objects 113. As such, the recovery modeling subsystem 142 may approximate more real-world recovery. This modeling may be in addition to or instead of estimating recovery times by simply using the number of devices and their overall capacity. By itself, estimating recovery times by simply using the number of devices and their overall capacity may be an over-simplification of real-world recovery processes since actual recovery times may not be based on perfect and serial execution of the recovery devices. To do so, the bin packing model 148 may use an active bin 144 and a queue 146.

The active bin 144 may store (in memory such as memory 140) data objects 113 that are currently being recovered in a simulated recovery by the recovery system 110. The active bin 144 may therefore be based on the recovery pattern 114 of the recovery system 110 that is to recover the CNS 101. In other words, the number of data objects 113 in the active bin 144 may be based on the concurrent recovery limit of the recovery, which may be parameterized in the recovery pattern 114.

The queue 146 may store (in memory such as memory 140) data objects that are waiting to be recovered in the simulated recovery. Upon instantiation, the active bin 144 will be filled with the plurality of data objects 113 that can be processed based on the recovery pattern 114 and the queue 146 will include the remaining data objects 113. As a data object 113 in the active bin 144 is recovered based on the recovery pattern 114, recovery of another data object 113 may be made available. As such, the bin packing model 148 may move a data object 113 in the queue 146 to the active bin 144 as recovery progresses.

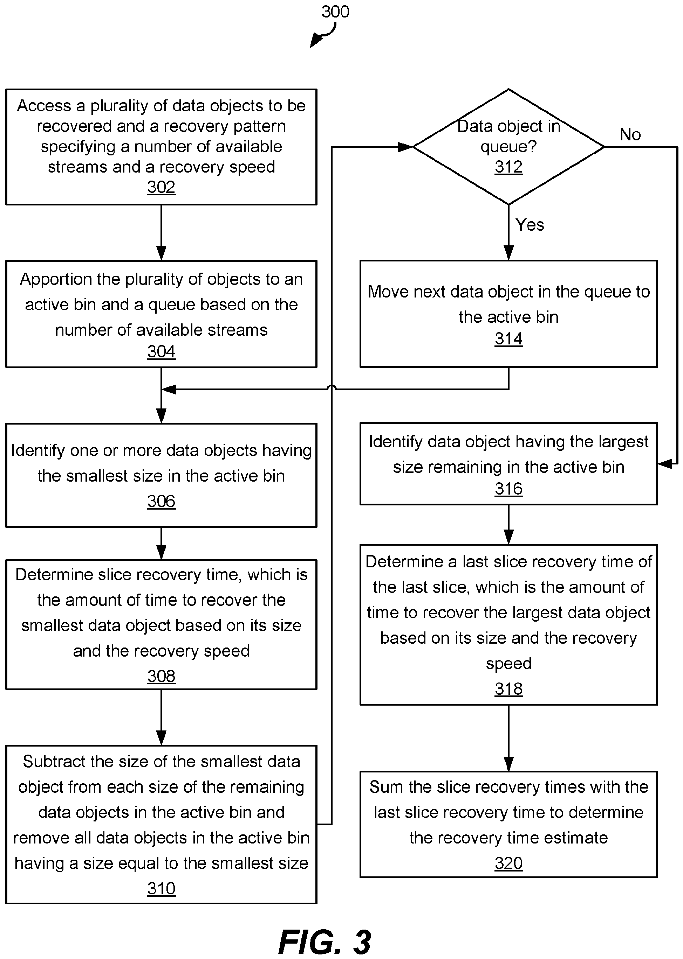

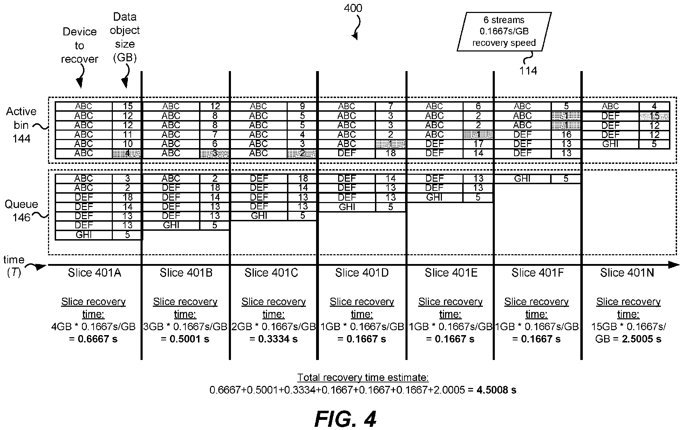

FIG. 3 illustrates an example of a method 300 used by the bin packing model 148 for estimating recovery time. Discussion of the method 300 will make reference to FIG. 4, which illustrates an example of queuing data objects to be recovered for estimating recovery time based on the bin packing model 148.

At 302, the method 300 may include accessing a plurality of data objects 113 to be recovered and a recovery pattern 114 specifying a number of available streams and a recovery speed of each stream.

At 304, the method 300 may include apportioning the plurality of objects 113 to an active bin 144 and a queue 146 based on the number of available streams. For example, referring to FIG. 4, the illustrated example includes six available streams that can each stream 0.16667 GB per second. Thus, the active bin 144 includes six slots for recovering six data objects 113. Each device to which a data object 113 is to be restored is illustrated by three capitalized letters ("ABC"; "DEF"; and "GHI"). The illustrated example is made for illustration and not limitation - other numbers of devices and data objects 113 may be used, and different sizes of each data object 113 may exist. The six data objects 113 are recovered and streamed to their respective devices ("ABC," "DEF," or "GHI") over time (*T*). Recovery times may be measured over time slices (illustrated as slices 401A-N). Other numbers of slices 401 will exist depending on the data objects 113 to be recovered and the number of available streams. A slice 401 means a representation of a period of time in which data objects 113 in the active bin 144 are being recovered. A slice 401 starts when the active bin 144 is initially processed (the first slice 401A) or when a data object 113 from a prior slice has been recovered such as streamed to its respective device that requires the data object 113 (subsequent slices 401B-N). A slice 401 ends when another slice begins or when the last data object 113 has been recovered. Further details of slices 401 will be described below.

At 306, the method 300 may include identifying one or more data objects 113 having the smallest size in the active bin 144 that is being processed in a given slice 401. For example, the smallest size in the active bin 144 for slice 401A is 4GB. It should be noted that more than one data object 113 may have the smallest size in a given slice 401F has two data objects with size "1".

At 308, the method 300 may include determining a slice recovery time, which is the amount of time to recover the smallest data object 113 based on its size and the recovery speed. For example, the slice recovery time for slice 401A is based on the time it takes to recover the smallest data object 113 having a size of 4 Gigabytes (GB) at the recovery speed of 0. 16667 seconds (s)/GB, which is equal to 0.6667 seconds.

At 310, the method 300 may include subtracting the size of the smallest data object from each size of the remaining data objects in the active bin 144 and removing all data objects 113 in the active bin 144 that have a size equal to the smallest size. Doing so simulates recovering the removed data objects 113 and ends a corresponding slice 401. For example, the data object 113 with 4GB size is removed from the active bin 144, ending the slice 401A. Referring to slice 401B, 4GB has been subtracted from the size of each of the data objects 113 that remain from slice 401A.

At 312, the method 300 may include determining whether more data objects 113 are in the queue 146.

If yes (meaning that the queue 146 is not empty), at 314, the method 300 may include moving a next data object in the queue 146 to the active bin 144. For example, referring back to slice 401A, there are multiple data objects 113 remaining in the queue 146. Thus, the next data object in the queue corresponding to device ABC having a size of 3GB is moved from the queue 146 to the next available slot in the active bin 144 (previously occupied by the data object corresponding to device ABC having a size of 4GB). It should be noted that more than one data object 113 may be moved from the queue 146 to the active bin 144 at a given slice transition. For example, two data objects are moved in the slice transition between slices 401E and 401F. Moving one or more data objects from the queue 146 to the active bin 144 starts the next slice. The method 300 may then return to 306 to repeat 306-312 to continue recovering data objects 113 in the active bin 144 and emptying the queue 146. It should be noted that recovery of data objects 113 in the active bin 144 (such as allocating data objects 113 into the active bin 144 and/or recovering data objects in the active bin 144) and/or emptying the queue 146 may be made based on a priority ordering specified in the original request to estimate recovery, first-in-first-out (FIFO), randomly, and/or other manner.

Returning to 312, if no more data objects 113 are in the queue 146 (when the queue 146 is empty such as is the case for slice 401N), Then the method 300 may proceed to 316, which may include identifying the data object 113 having the largest size remaining in the active bin 144. For example, the largest data object in the last slice 401N is 15GB.

At 318, the method 300 may include determining a last slice recovery time for the last slice (slice 401N in the example of FIG. 4), which is the amount of time to recover the largest data object based on its size and the recovery speed. Thus, the recovery time for the last slice is 15GB * 0.1667s/GB, or 2.5005 s.

At 320, the method 300 may include summing the slice recovery times with the last slice recovery time to determine the recovery time estimate. In illustrated example of FIG. 4, the summed slice recovery times is equal to 0.6667+0.5001+0.3334+0.1667+0.1667+0.1667+2.0005 = 4.5008 seconds.

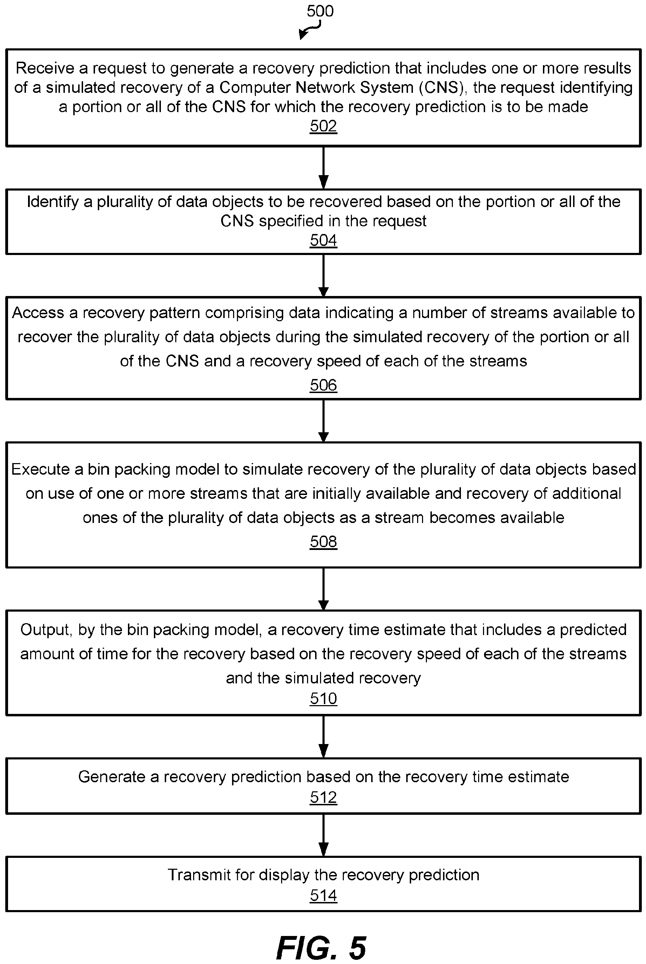

FIG. 5 illustrates an example of a method 500 for generating a recovery prediction based on recovery modeling of a CNS 101. At 502, the method 500 may include receiving a request to generate a recovery prediction that includes one or more results of a simulated recovery of a CNS 101. The request may identify a portion or all of the CNS for which the recovery prediction is to be made.

At 504, the method 500 may include identifying a plurality of data objects 113 to be recovered based on the portion or all of the CNS 101 specified in the request. At 506, the method 500 may include accessing a recovery pattern 114 comprising data indicating a number of streams available to recover the plurality of data objects 113 during the simulated recovery of the portion or all of the CNS 101 and a recovery speed of each of the streams.

At 508, the method 500 may include executing a bin packing model 148 to simulate recovery of the plurality of data objects 113 based on use of one or more streams that are initially available and recovery of additional ones of the plurality of data objects as a stream becomes available. Recovery of additional ones of the plurality of data objects as a stream becomes available may reduce idle times of the streams during the simulated recovery. A stream may be determined to become available based on the recovery speed of the stream and a size of a data object recovered by the stream.

At 510, the method 500 may include outputting, by the bin packing model 148, a recovery time estimate that includes a predicted amount of time for the recovery based on the recovery speed of each of the streams and the simulated recovery.

At 512, the method 500 may include generating a recovery prediction 103 based on the recovery time estimate. At 514, the method 500 may include transmitting for display the recovery prediction 103. For example, the recovery prediction 103 may be transmitted to a device 160 from which the request was received.

It should be noted that more than one recovery pattern 114 may be used for recovery modeling. For example, an entity that operates the CNS 101 may use multiple recovery systems 110 each made by different vendors. In this example, a first vendor may provide a first recovery system 110 having a first capability (such as number of streams and/or recovery speed). A second vendor may provide a second recovery system 110 having a second capability that is different than the first capability. A third vendor may provide a third recovery system 110 having a third capability that is different than the first and/or the second capability, and so on. To model these and other differences, the system may use multiple (such as first, second and third) recovery patterns each corresponding to respective recovery systems 110 (such as the first, second and third recovery systems, respectively). In some examples, based on priority information that prioritizes certain services or LOBs to be recovered first, different recovery systems 110 may recover the services or LOBs in different orders. Whichever order the recovery occurs based on the priority information, the recovery patterns corresponding to the respective recovery system will be used to simulate recovery by those recovery systems.

The datastores (such as the backup datastore 111 and the recovery pattern datastore 112) may be, include, or interface to, for example, an Oracle^{™} relational database sold commercially by Oracle Corporation. Other databases, such as Informix^{™}, DB2 or other data storage, including file-based, or query formats, platforms, or resources such as OLAP (On Line Analytical Processing), SQL (Structured Query Language), a SAN (storage area network), Microsoft Access^{™} or others may also be used, incorporated, or accessed. The database may comprise one or more such databases that reside in one or more physical devices and in one or more physical locations. The database may include cloud-based storage solutions. The database may store a plurality of types of data and/or files and associated data or file descriptions, administrative information, or any other data. The various databases may store predefined and/or customized data described herein.

Although not illustrated, device 160 may include a memory similar to the memory 140. That is, the device 160 may include an electronic storage. The electronic storage may include non-transitory storage media that electronically stores information. The electronic storage media of the electronic storages may include one or both of (i) system storage that is provided integrally (e.g., substantially non-removable) with servers or client devices or (ii) removable storage that is removably connectable to the servers or client devices via, for example, a port (e.g., a USB port, a firewire port, etc.) or a drive (e.g., a disk drive, etc.). The electronic storages may include one or more of optically readable storage media (e.g., optical disks, etc.), magnetically readable storage media (e.g., magnetic tape, magnetic hard drive, floppy drive, etc.), electrical charge-based storage media (e.g., EEPROM, RAM, etc.), solid-state storage media (e.g., flash drive, etc.), and/or other electronically readable storage media. The electronic storages may include one or more virtual storage resources (e.g., cloud storage, a virtual private network, and/or other virtual storage resources). The electronic storage may store software algorithms, information determined by the processors, information obtained from servers, information obtained from client devices, or other information that enables the functionalities described herein.

The computer system 120 and the one or more devices 160 may be connected to one another via a communication network (not illustrated), such as the Internet or the Internet in combination with various other networks, like local area networks, cellular networks, or personal area networks, internal organizational networks, and/or other networks. It should be noted that the computer system 120 may transmit data, via the communication network, conveying the grid patterns one or more of the devices 160. Although not shown, the one or more devices 160 may each include one or more processors.

The systems and processes are not limited to the specific implementations described herein. In addition, components of each system and each process can be practiced independent and separate from other components and processes described herein. Each component and process also can be used in combination with other assembly packages and processes. The flow charts and descriptions thereof herein should not be understood to prescribe a fixed order of performing the method blocks described therein. Rather the method blocks may be performed in any order that is practicable including simultaneous performance of at least some method blocks. Furthermore, each of the methods may be performed by the computer system 120 illustrated in FIG. 1.

This written description uses examples to disclose the implementations, including the best mode, and to enable any person skilled in the art to practice the implementations, including making and using any devices or systems and performing any incorporated methods. The patentable scope of the disclosure is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

Here follows a list of clauses highlighting various aspects of the present disclosure.
Clause 1. A system, comprising:
   a processor programmed to:
   receive a request to generate a recovery prediction that includes one or more results of a simulated recovery of a Computer Network System (CNS), the request identifying a portion or
   all of the CNS for which the recovery prediction is to be made;
   identify a plurality of data objects to be recovered based on the portion or all of the CNS specified in the request;
   access a recovery pattern comprising data indicating a number of streams available to recover the plurality of data objects during the simulated recovery of the portion or all of the CNS and a recovery speed of each of the streams;
   execute a bin packing model to simulate recovery of the plurality of data objects based on use of one or more streams that are initially available and recovery of additional ones of the plurality of data objects as a stream becomes available;
   output, by the bin packing model, a recovery time estimate that includes a predicted amount of time for the recovery based on the recovery speed of each of the streams and the simulated recovery;
   generate a recovery prediction based on the recovery time estimate; and
   transmit for display the recovery prediction.
Clause 2. The system of clause 1, further comprising:
   an active bin that stores a number of data objects based on the number of streams available to recover data objects, and a queue that stores one or more of the plurality data objects that are not in the active bin and are not yet recovered;
   wherein the bin packing model, executed by the processor, is to:
      add a number of the plurality of data objects to the active bin based on the number of streams available to recover data objects and adds any remainder of the plurality of data objects to the queue;
      simulate recovery of data objects from the active bin;
      as one or more data objects in the active bin is recovered, add one or more next data objects in the queue to the active bin for recovery.
Clause 3. The system of clause 2, wherein, when the queue is not empty, the processor is programmed to execute the bin packing model to: (i) identify a size of a data object in the active bin having a smallest size from among the data objects in the active bin;
   (ii) subtract the smallest size from each size of other data objects in the active bin,
   (iii) determine the data object in the active bin having the smallest size is recovered in the recovery simulation,
   (iv) determine a slice recovery time based on the smallest size and the recovery speed, wherein the recovery time estimate is based on the slice recovery time, wherein the one or more next data objects in the queue is added to the active bin without having the smallest size subtracted from a size of the one or more next data objects, and
   repeat (i)-(iv) until the queue is empty.
Clause 4. The system of clause 3, wherein, when the queue is empty, the processor is programmed to execute the bin packing model to:
   identify a size of a data object in the active bin having a largest size from among the data objects in the active bin; and
   determine a last slice recovery time based on the largest size and the recovery speed, wherein the recovery time estimate is based on the largest slice recovery time and previously determined slice recovery times.
Clause 5. The system of clause 1, wherein the request further comprises priority information that specifies an order in which recovery is to proceed, wherein recovery of the plurality of data objects is ordered based on the priority information.
Clause 6. The system of clause 1, wherein the request further comprises a parameter that imposes a restriction on a capacity to perform recovery, and wherein the processor is further programmed to reduce the number of streams and/or the recovery speed based on the parameter.
Clause 7. The system of clause 1, wherein the request further comprises a recovery requirement that specifies a preferred recovery condition, and wherein the processor is further programmed to:
   iteratively execute the bin packing model using different combinations of available streams and/or recovery speeds to meet the preferred recovery condition.
Clause 8. The system of clause 1, wherein the portion or all of the CNS corresponds to a minimum Line of Business (LOB) that requires recovery of a minimum number of devices and their corresponding data objects, wherein the processor is further programmed to identify the plurality of data objects based on the corresponding data objects.
Clause 9. The system of clause 1, wherein the portion or all of the CNS corresponds to one or more applications of the CNS and their corresponding data objects, wherein the processor is further programmed to identify the plurality of data objects based on the corresponding data objects.
Clause 10. The system of clause 1, wherein the portion or all of the CNS corresponds to one or more Lines of Business (LOBs) of the CNS and their corresponding data objects, wherein the processor is further programmed to identify the plurality of data objects based on the corresponding data objects.
Clause 11. The system of clause 1, wherein the CNS is recovered by a recovery system and the recovery pattern is based on capabilities of the recovery system.
Clause 12. The system of clause 11, wherein the recovery system is associated with different sets of vendor devices that recover the CNS, and wherein the recovery pattern comprises a plurality of recovery patterns that each correspond to a respective set of vendor devices.
Clause 13. The system of clause 1, wherein a stream is determined to become available based on the recovery speed of the stream and a size of a data object recovered by the stream.
Clause 14. A non-transitory computer readable medium storing instructions that, when executed by a processor, programs the processor to:
   receive a request to generate a recovery prediction that includes one or more results of a simulated recovery of a Computer Network System (CNS), the request identifying a portion or all of the CNS for which the recovery prediction is to be made;
   identify a plurality of data objects to be recovered based on the portion or all of the CNS specified in the request;
   access a recovery pattern comprising data indicating a number of streams available to recover the plurality of data objects during the simulated recovery of the portion or all of the CNS and a recovery speed of each of the streams;
   execute a bin packing model to simulate recovery of the plurality of data objects based on use of one or more streams that are initially available and recovery of additional ones of the plurality of data objects as a stream becomes available;
   output, by the bin packing model, a recovery time estimate that includes a predicted amount of time for the recovery based on the recovery speed of each of the streams and the simulated recovery;
   generate a recovery prediction based on the recovery time estimate; and transmit for display the recovery prediction.
Clause 15. The non-transitory computer readable medium of clause 14, wherein the non-transitory computer readable medium further stores:
   an active bin that stores a number of data objects based on the number of streams available to recover data objects, and a queue that stores one or more of the plurality data objects that are not in the active bin and are not yet recovered;
   wherein the bin packing model, executed by the processor, is to:
      add a number of the plurality of data objects to the active bin based on the number of streams available to recover data objects and adds any remainder of the plurality of data objects to the queue;
      simulate recovery of data objects from the active bin;
      as one or more data objects in the active bin is recovered, add one or more next data objects in the queue to the active bin for recovery.
Clause 16. The non-transitory computer readable medium of clause 15, wherein the instructions, when executed by the processor further cause the processor to:
   to simulate recovery when the queue is not empty:
      (i) identify a size of a data object in the active bin having a smallest size from among the data objects in the active bin;
      (ii) subtract the smallest size from each size of other data objects in the active bin,
      (iii) determine the data object in the active bin having the smallest size is recovered in the recovery simulation,
      (iv) determine a slice recovery time based on the smallest size and the recovery speed, wherein the recovery time estimate is based on the slice recovery time, and wherein the one or more next data objects in the queue is added to the active bin without having the smallest size subtracted from a size of the one or more next data objects, and
   repeat (i)-(iv) until the queue is empty.
Clause 17. The non-transitory computer readable medium of clause 16, wherein the instructions, when executed by the processor further cause the processor to:
   to simulate recovery when there the queue is empty:
   identify a size of a data object in the active bin having a largest size from among the data objects in the active bin;
   determine a last slice recovery time based on the largest size and the recovery speed, wherein the recovery time estimate is based on a largest slice recovery time and previously determined slice recovery times.
Clause 18. The non-transitory computer readable medium of clause 14, wherein the request further comprises priority information that specifies an order in which recovery is to proceed, wherein recovery of the plurality of data objects is ordered based on the priority information.
Clause 19. The non-transitory computer readable medium of clause 14, wherein the portion or all of the CNS corresponds to a minimum Line of Business (LOB) that requires recovery of a minimum number of devices and their corresponding data objects, wherein the processor is further programmed to identify the plurality of data objects based on the corresponding data objects.
Clause 20. A method of determining a recovery time estimate based on recovery modeling, the method comprising:
   accessing, by a processor, a plurality of data objects to be recovered and a recovery pattern specifying a number of available streams and a recovery speed of each stream;
   apportioning, by the processor, the plurality of objects to an active bin and a queue based on the number of available streams;
      (i) identifying, by the processor, one or more data objects having a smallest size in the active bin that is being processed in a given slice;
      (ii) determining, by the processor, a slice recovery time, which is an amount of time to recover the smallest data object based on its size and the recovery speed
      (iii) subtracting, by the processor, the size of the smallest data object from each size of remaining data objects in the active bin and removing all data objects in the active bin that have a size equal to the smallest size;
      (iv) determining, by the processor, that the queue is not empty;
      (v) moving, by the processor, a next data object in the queue to the active bin; and
      (vi) repeating, by the processor, (i)-(v) until the queue is empty;
   determining, by the processor, that the queue is empty;
   identifying, by the processor, the data object having a largest size remaining in the active bin; determining, by the processor, a last slice recovery time for the last slice based on the largest size and the recovery speed;
   summing, by the processor, slice recovery times from (i)-(vi) with the last slice recovery time to determine the recovery time estimate.
Clause 21. The method of clause 20, further comprising:
   accessing priority information comprising data that specifies a priority order in which to perform recovery, wherein apportioning the plurality of objects to the active bin and the queue is based on the priority order.

The claims follow hereafter.

## Claims

1. A system, comprising:
a processor programmed to:
receive a request to generate a recovery prediction that includes one or more results of a simulated recovery of a Computer Network System (CNS), the request identifying a portion or all of the CNS for which the recovery prediction is to be made;
identify a plurality of data objects to be recovered based on the portion or all of the CNS specified in the request;
access a recovery pattern comprising data indicating a number of streams available to recover the plurality of data objects during the simulated recovery of the portion or all of the CNS and a recovery speed of each of the streams;
execute a bin packing model to simulate recovery of the plurality of data objects based on use of one or more streams that are initially available and recovery of additional ones of the plurality of data objects as a stream becomes available;
output, by the bin packing model, a recovery time estimate that includes a predicted amount of time for the recovery based on the recovery speed of each of the streams and the simulated recovery;
generate a recovery prediction based on the recovery time estimate; and
transmit for display the recovery prediction.

2. The system of claim 1, further comprising:
an active bin that stores a number of data objects based on the number of streams available to recover data objects, and a queue that stores one or more of the plurality data objects that are not in the active bin and are not yet recovered;
wherein the bin packing model, executed by the processor, is to:
add a number of the plurality of data objects to the active bin based on the number of streams available to recover data objects and adds any remainder of the plurality of data objects to the queue;
simulate recovery of data objects from the active bin;
as one or more data objects in the active bin is recovered, add one or more next data objects in the queue to the active bin for recovery.

3. The system of claim 2, wherein, when the queue is not empty, the processor is programmed to execute the bin packing model to: (i) identify a size of a data object in the active bin having a smallest size from among the data objects in the active bin;
(ii) subtract the smallest size from each size of other data objects in the active bin,
(iii) determine the data object in the active bin having the smallest size is recovered in the recovery simulation,
(iv) determine a slice recovery time based on the smallest size and the recovery speed, wherein the recovery time estimate is based on the slice recovery time, wherein the one or more next data objects in the queue is added to the active bin without having the smallest size subtracted from a size of the one or more next data objects, and
repeat (i)-(iv) until the queue is empty.

4. The system of claim 3, wherein, when the queue is empty, the processor is programmed to execute the bin packing model to:
identify a size of a data object in the active bin having a largest size from among the data objects in the active bin; and
determine a last slice recovery time based on the largest size and the recovery speed, wherein the recovery time estimate is based on the largest slice recovery time and previously determined slice recovery times.

5. The system of any one of the preceding claims, wherein the request further comprises priority information that specifies an order in which recovery is to proceed, wherein recovery of the plurality of data objects is ordered based on the priority information.

6. The system of any one of the preceding claims, wherein the request further comprises a parameter that imposes a restriction on a capacity to perform recovery, and wherein the processor is further programmed to reduce the number of streams and/or the recovery speed based on the parameter.

7. The system of any one of the preceding claims, wherein the request further comprises a recovery requirement that specifies a preferred recovery condition, and wherein the processor is further programmed to:
iteratively execute the bin packing model using different combinations of available streams and/or recovery speeds to meet the preferred recovery condition.

8. The system of any one of the preceding claims, wherein the portion or all of the CNS corresponds to a minimum Line of Business (LOB) that requires recovery of a minimum number of devices and their corresponding data objects, wherein the processor is further programmed to identify the plurality of data objects based on the corresponding data objects.

9. The system of any one of the preceding claims, wherein the portion or all of the CNS corresponds to one or more applications of the CNS and their corresponding data objects, wherein the processor is further programmed to identify the plurality of data objects based on the corresponding data objects.

10. The system of any one of the preceding claims, wherein the portion or all of the CNS corresponds to one or more Lines of Business (LOBs) of the CNS and their corresponding data objects, wherein the processor is further programmed to identify the plurality of data objects based on the corresponding data objects.

11. The system of any one of the preceding claims, wherein the CNS is recovered by a recovery system and the recovery pattern is based on capabilities of the recovery system.

12. The system of claim 11, wherein the recovery system is associated with different sets of vendor devices that recover the CNS, and wherein the recovery pattern comprises a plurality of recovery patterns that each correspond to a respective set of vendor devices.

13. The system of any one of the preceding claims, wherein a stream is determined to become available based on the recovery speed of the stream and a size of a data object recovered by the stream.

14. A non-transitory computer readable medium storing instructions that, when executed by a processor, programs the processor to:
receive a request to generate a recovery prediction that includes one or more results of a simulated recovery of a Computer Network System (CNS), the request identifying a portion or all of the CNS for which the recovery prediction is to be made;
identify a plurality of data objects to be recovered based on the portion or all of the CNS specified in the request;
access a recovery pattern comprising data indicating a number of streams available to recover the plurality of data objects during the simulated recovery of the portion or all of the CNS and a recovery speed of each of the streams;
execute a bin packing model to simulate recovery of the plurality of data objects based on use of one or more streams that are initially available and recovery of additional ones of the plurality of data objects as a stream becomes available;
output, by the bin packing model, a recovery time estimate that includes a predicted amount of time for the recovery based on the recovery speed of each of the streams and the simulated recovery;
generate a recovery prediction based on the recovery time estimate; and
transmit for display the recovery prediction.

15. A method of determining a recovery time estimate based on recovery modeling, the method comprising:
accessing, by a processor, a plurality of data objects to be recovered and a recovery pattern specifying a number of available streams and a recovery speed of each stream;
apportioning, by the processor, the plurality of objects to an active bin and a queue based on the number of available streams;
(i) identifying, by the processor, one or more data objects having a smallest size in the active bin that is being processed in a given slice;
(ii) determining, by the processor, a slice recovery time, which is an amount of time to recover the smallest data object based on its size and the recovery speed
(iii) subtracting, by the processor, the size of the smallest data object from each size of remaining data objects in the active bin and removing all data objects in the active bin that have a size equal to the smallest size;
(iv) determining, by the processor, that the queue is not empty;
(v) moving, by the processor, a next data object in the queue to the active bin; and
(vi) repeating, by the processor, (i)-(v) until the queue is empty;
determining, by the processor, that the queue is empty;
identifying, by the processor, the data object having a largest size remaining in the active bin;
determining, by the processor, a last slice recovery time for the last slice based on the largest size and the recovery speed;
summing, by the processor, slice recovery times from (i)-(vi) with the last slice recovery time to determine the recovery time estimate.
